# EUROPÄISCHE PATENTSCHRIFT

(11) **EP 3 072 197 B1**
(45) Veröffentlichungstag und Bekanntmachung des Hinweises auf die Patenterteilung: **08.01.2020**
(21) Anmeldenummer: 14802850.9
(22) Anmeldetag: 19.11.2014
(51) Int. Cl.: G01W 1/10, G01R 29/14, H02G 13/00, G01R 29/08, G01W 1/16

(54) **VERFAHREN UND WINDENERGIEANLAGE ZUR BLITZWARNUNG**
METHOD AND WIND TURBINE FOR WARNING OF LIGHTNING
PROCÉDÉ ET ÉOLIENNE POUR L'ALERTE DE FOUDRE

(30) Priorität: 19.11.2013 DE 102013223592
(43) Veröffentlichungstag der Anmeldung: 28.09.2016
(73) Patentinhaber: Wobben Properties GmbH, 26607 Aurich (DE)
(72) Erfinder: GROENHAGEN, Jannes, 26623 Südbrookmerland (DE)
(74) Vertreter: Eisenführ Speiser
(86) Internationale Anmeldenummer: PCT/EP2014/075007
(87) Internationale Veröffentlichungsnummer: WO 2015/075067

(56) Entgegenhaltungen:
- EP-A2- 1 944 627
- EP-A2- 2 190 092
- WO-A1-92/10804
- DE-A1-102004 000 025
- DE-B3-102011 122 807
- JP-A- H07 151 866
- JP-A- 2000 065 953
- JP-A- 2013 054 006
- US-A1- 2003 067 731
- US-A1- 2012 162 845

## Beschreibung

Die Erfindung betrifft ein Verfahren zur Blitzwarnung mit einer Mehrzahl von Windenergieanlagen, gemäß dem unabhängigen Anspruch 1 und ein System einer Mehrzahl von Windenergieanlagen ausgebildet zur Blitzwarnung gemäß Anspruch 6.

Windenergie und Windkraft nehmen bei der globalen Stromerzeugung einen immer größeren Anteil und damit einen wichtigen Stellenwert ein. Mit steigender Anzahl von Windenergieanlagen und Windparkanlagen nehmen aber auch gleichzeitig der Wartungsaufwand und Wartungszeit der Windenergieanlagen und Windparks zu. Ein hoher Wartungsaufwand ist jedoch mit einem hohen Kostenaufwand und einer hohen logistischen Planung der Wartungsarbeiten und des Wartungspersonales verbunden. Ein wichtiger Gesichtspunkt bei der Planung der Wartungsarbeiten ist es, unnötige Ausfallzeiten zu vermeiden, bei denen Wartungsarbeiten aufgrund von Witterungsbedingungen, insbesondere bei Gewitter mit Blitzeinschlägen in Windenergieanlagen, unterbrochen werden. Besonders bei Windenergieanlagen besteht eine erhöhte Wahrscheinlichkeit für einen Blitzeinschlag, da diese auf Grund ihrer Konstruktion oftmals den höchsten Punkt in der Umgebung bilden und somit ein bevorzugter Punkt für atmosphärische Entladungen sind.

Für eine Blitz- und/oder Gewitterwarnung werden typischerweise die öffentlichen Wettervorhersagen verwendet, die lokal, insbesondere was einen bestimmten Standort einer Windenergieanlage betrifft, sehr ungenau sind bzw. eine Blitzvorhersage überhaupt nicht erlauben.

Die Vorhersage für einen Blitzeinschlag in einer Windenergieanlage, insbesondere während der Dauer der Wartungsarbeiten, muss jedoch sehr zuverlässig sein, da im Falle eines tatsächlichen Blitzeinschlages ein hohes Sicherheitsrisiko und sogar Lebensgefahr für das Wartungspersonal besteht. Auf der anderen Seite soll eine Unterbrechung der Wartungsarbeiten aber nur dann erfolgen, wenn tatsächlich eine hinreichende Wahrscheinlichkeit für einen Blitzeinschlag besteht, um die Wartungsarbeiten nicht unnötig zu unterbrechen.

Wünschenswert wäre es deshalb, ein Verfahren und eine Vorrichtung bereitzustellen, mit welche(m)(r) es möglich ist, einen Blitz, insbesondere einen Blitzeinschlag in einer bestimmten Windenergieanlage, frühzeitig vorherzusagen beziehungsweise zu erkennen und eine entsprechende Warnmeldung auszugeben, so dass das Wartungspersonal die Wartungsarbeiten unterbrechen und/oder die Windenergieanlage abgeschaltet werden kann. Ist die Gefahr des Blitzeinschlags anschließend gebannt, können die Wartungsarbeiten wieder aufgenommen und/oder die Windenergieanlage wieder eingeschaltet werden. Insbesondere wäre es wünschenswert den potentiellen Ort und die Zeit eines Blitzeinschlages in präziser und zuverlässiger Weise vorherzusagen.

Für die Wettervorhersage, insbesondere auch für die Gewittervorhersage, ist bekannt aus einem vergangenen und einem aktuellen Wetterzustand der Atmosphäre, unter Verwendung bekannter physikalischer Regeln, einen Zustand der Atmosphäre für die Zukunft abzuleiten bzw. vorherzusagen. Hierbei werden sogenannte nichtlineare Gleichungen verwendet, bei denen bereits kleine Änderungen in den Anfangsbedingungen zu einer großen Variation der Ergebnisse, vorliegend der Wetterprognose, führen. Dieses Phänomen ist auch unter dem Stichwort Schmetterlingseffekt bekannt.

Die Anfangsbedingungen oder Daten, insbesondere die Messdaten oder Messwerte für die Umwelt- und/oder Atmosphärenbedingungen, welche Informationen über den aktuellen Zustand der Atmosphäre geben, werden mit einem Netz von Bodenmessstationen erfasst. Die Messstationen erfassen dabei typischerweise Windgeschwindigkeit, Temperatur, Luftdruck und Luftfeuchtigkeit sowie Niederschlagsmenge. Nur wenn hinreichend viele Messstationen vorhanden sind, die Wetterdaten sammeln, ist eine zuverlässige Wettervorhersage möglich.

Die aus dem Stand der Technik bekannten Messstationen sind jedoch oftmals in Bodennähe angeordnet, sodass die erfassten (Wetter-)Messdaten, insbesondere die Umweltparameter, von Bodeneffekten, beispielweise von der Wärme oder Kälte, die im Boden gespeichert ist, verfälscht werden. Falsche Messdaten erlauben aber keine zuverlässige Wettervorhersage für einen bestimmten Ort. Darüberhinaus werden mit den bekannten Bodenmessstationen auch keine Daten über elektrische oder elektromagnetische Felder gesammelt, so dass eine Blitzvorhersage praktisch unmöglich ist.

Das Deutsche Patent- und Markenamt hat zur Sache folgende Dokumente recherchiert: DE 10 2012 222 973 A1, AT 389 012 B und brieselang.net (Internetseite zum vorbeugenden Blitzschutz). Zusätzlicher Stand der Technik ist noch in US 2012/162845 A1 und JP 2013 054006 A zu finden.

An dieser Stelle setzt die Erfindung an, deren Aufgabe es ist, ein verbessertes Verfahren und eine verbesserte Vorrichtung und/oder ein verbessertes System zur Wettervorhersage, insbesondere zur Gewitter- und/oder Blitzwarnung, zur Verfügung zu stellen, das/die hinsichtlich des Standes der Technik verbessert sind, wenigstens aber an eines der oben genannten Probleme adressiert sind. Insbesondere ist es Aufgabe der Erfindung, ein Verfahren und eine Vorrichtung zur Blitzwarnung mit einer Mehrzahl von Windenergieanlagen bereitzustellen.

Diese Aufgabe wird erfindungsgemäß durch das Verfahren zur Blitzwarnung mit einer Mehrzahl von Windenergieanlagen, insbesondere mit einem Teil eines Windparkes, gemäß Anspruch 1 und einer Windenergieanlage und/oder einem Windpark und/oder einem Netz aus Windenergieanlagen und/oder einem Netz aus Windparkanlagen gemäß Anspruch 11 und eine Verwendung einer Windenergieanlage und/oder einer Windparkanlage und/oder eines Netzes aus Windenergieanlagen und/oder eines Netzes aus Windparkanlagen zur Bildung eines Systems zur Wettervorhersage gemäß Anspruch 13 gelöst.

Die Erfindung umfasst den Gedanken eines Verfahrens zur Blitzwarnung mit einer Mehrzahl von Windenergieanlagen, insbesondere mit einem Teil eines Windparks, wobei die Mehrzahl der Windenergieanlagen jeweils an einem Standort stehen und jede der Mehrzahl von Windenergieanlagen eine Sensoranordnung zur Erfassung eines Umweltparameters aufweist, umfassend wenigstens einen Windmesser, einen Temperatursensor und/oder einen Feuchtigkeitssensor, wobei die Sensoranordnung einen weiteren Sensor, insbesondere ein Elektrofeldmeter, zum Erfassen von elektrischen Feldern aufweist, und das Verfahren die folgenden Schritte umfasst, nämlich ein Erfassen von mindestens einem Wert für den Umweltparameter, wenigstens umfassend ein elektrisches Feld, mit Hilfe der Sensoren der Sensoranordnung mit der Mehrzahl der Windenergieanlagen; und ein Auswerten des mindestens einen Wertes für den Umweltparameter zur Vorhersage der Blitzwarnung für die Standorte der Mehrzahl der Windenergieanlagen.

Des Weiteren umfasst die Erfindung den Gedanken einer Windenergieanlage und/oder eines Windparks mit einer Mehrzahl von Windenergieanlage und/oder eines Netzes aus Windenergieanlagen und/oder eines Netz aus Windparks, zur Blitzwarnung, wobei die Windenergieanlage und die Mehrzahl der Windenergieanlagen jeweils an einem Standort stehen und jede der Windenergieanlagen eine Sensoranordnung zur Erfassung eines Umweltparameters aufweist, umfassend wenigstens einen Windmesser, einen Temperatursensor und/oder einen Feuchtigkeitssensor, und die Sensoranordnung einen weiteren Sensor, insbesondere ein Elektrofeldmeter, zum Erfassen eines elektrischen Feldes aufweist; und eine Blitzwarneinrichtung mit einer Auswerteeinheit zum Auswerten des mindestens einen Wertes für den Umweltparameter, wenigstens umfassend ein elektrisches Feld, und zum Vorhersagen der Blitzwarnung für die Standorte der Windenergieanlagen gebildet ist.

Im Folgenden wird das Konzept der Erfindung beispielhaft - ohne die Erfindung dabei einzuschränken - beschrieben. Die Erfindung sieht vor, Windenergieanlagen, insbesondere mehrere Windenergieanlagen eines Windparkes, als Wettermessstationen zur Wettervorhersage, insbesondere zur Gewittervorhersage und/oder Blitzwarnung, zu verwenden. Hierbei wird also eine Anzahl i von Windenergieanlagen als Wettermessstationen verwendet, wobei i einen Zahlenwert von i = 1, 2, ... ,n annehmen kann. Windenergieanlagen als Wettermessstationen haben den Vorteil, dass sie bereits über mehrere, verschiedene Sensoren umfassen, wie zum Beispiel Windmesser, Thermometer, Barometer und/oder Luftfeuchtigkeitssensoren. Darüber hinaus sind die Sensoren von Windenergieanlagen in großer Höhe von bis zu 200 Metern angeordnet, sodass die Messdaten nicht von Bodeneffekten beeinflusst oder verfälscht werden. Auch gibt es allein in Deutschland eine große Anzahl von mittlerweile über 23.000 einzelnen Windenergieanlagen, die als potentielle Wettermessstationen für das erfindungsgemäße Verfahren infrage kommen, sodass Umweltparameter mit einem dichten Netz aus Messstationen erfassten werden können.

Weiter ist nach dem Konzept der Erfindung vorgesehen, Windenergieanlagen mit einem zusätzlichen Sensor zur Erfassung von elektrischen Feldern, insbesondere auch magnetische und/oder elektromagnetischen Feldern, auszugestalten. Die Erfassung der elektrischen Felder, insbesondere der elektrischen Feldstärke eines elektrischen Feldes, in der Atmosphäre in der Umgebung der Windenergieanlage, lässt sich für eine präzise Vorhersage von Blitzen und Blitzeinschlägen nutzen. Hierbei berücksichtigt die Erfindung den Gedanken, dass es während eines Gewitters in der Atmosphäre, insbesondere in den Gewitterwolken, zu einer Ladungstrennung kommt, die lokal (in horizontaler und vertikaler Richtung) zu unterschiedlich starken elektrischen Feldstärken und/oder zu starken elektrischen Potentialgefällen führt. Diese elektrischen Felder/Feldstärken und/oder die Verteilung der elektrischen Feldstärke kann mit Hilfe der Sensoranordnung der einzelnen Windenergieanlagen, insbesondere dem zusätzlichen Sensor zur Erfassung von elektrischen Feldern, gemessen werden. Übersteigt die elektrische Feldstärke beispielsweise einen (vor-)bestimmten kritischen Wert für einen Blitzeinschlag, so wird eine Blitzwarnung ausgegeben. Insbesondere lässt sich mittels dem Erfassen und Auswerten von mehreren Umweltparametern, wie zum Beispiel Luftdruck, Temperatur und elektrische Feldstärke, eine Wahrscheinlichkeit für einen Blitzeinschlag in einer bestimmten Windenergieanlage bestimmen.

Darüber hinaus sieht das Konzept der Erfindung vor, Windenergieanlagen und/oder Windparkanlagen und/oder Netze aus Windenergieanlagen und/oder Windparkanlagen zu vernetzen und so ein System zur Wettervorhersage, insbesondere zur Gewitter- und/oder Blitzwarnung, bereitzustellen.

Diese und andere bevorzugte Ausgestaltungsformen der Erfindung sind Gegenstand der Unteransprüche und präzisieren sowohl das Verfahren als auch die Anordnung zur Blitzwarnung. Insbesondere sind bevorzugte Weiterbildungen Gegenstand der Unteransprüche und geben im Einzelnen vorteilhafte Möglichkeiten an, wie das oben erläuterte Verfahren beziehungsweise die Vorrichtung zur Blitzwarnung im Rahmen der Aufgabenstellung sowie hinsichtlich weiterer Vorteile zu realisieren beziehungsweise auszugestalten ist.

Bevorzugt sieht eine Ausgestaltung vor, dass die Mehrzahl der Windenergieanlagen mit einem Server in Verbindung stehen, insbesondere mit einem Server eines Windparks, und das Verfahren weiter die folgenden Schritte umfasst: Ein Senden des mindestens einen Wertes für den Umweltparameter von der Mehrzahl der Windenergieanlagen zum Server; ein Erstellen einer Karte mit dem mindestens einen Wert für den Umweltparameter und den Standorten der Mehrzahl der Windenergieanlagen; und ein Auswerten der Karte zur Vorhersage der Blitzwarnung für die Standorte der Mehrzahl der Windenergieanlagen. Hierbei sind die einzelnen Windenergieanlagen über Verbindungsleitungen mit einem Server verbunden, insbesondere mit einem Server des Windparks, so dass die mit der Sensoranordnung der jeweiligen Windenergieanlage erfassten Umweltparameter an den Server weitergeleitet werden können. Zusammen mit den erfassten Werte für den oder die Umweltparameter werden auch Informationen über den jeweiligen Standort der erfassenden Windenergieanlage an den Server übersendet, so dass der Sever, insbesondere ein entsprechend ausgebildetes Prozessorelement, in Lage ist aus den erfassten Umweltparametern und den Standorten der Windenergieanlagen eine Karte zu erstellen, auf welcher die Werte für den Umweltparameter, insbesondere deren Stärke, in Abhängigkeit von ihrem Standort angezeigt werden. Anschließend kann die erstellte Karte zur Vorhersage eines Blitzeinschlages, insbesondere zur Vorhersage eines Blitzeinschlages an einen bestimmten Standort einer bestimmten Windenergieanlage, ausgewertet werden. Für die Auswertung der erfassten Umweltparameter bzw. der erstellten Karte können beispielsweise Standardmodelle, wie sie aus der Wetterforschung und Wettervorhersage im Stand der Technik bekannt sind, verwendet werden.

Bei einer zweckmäßigen Ausgestaltung kann es vorgesehen sein, dass der mindestens eine und/oder die mehreren Werte die erfassten Wert für den Umweltparameter aus der folgenden Gruppe von Werten ausgewählt sind: Windstärke, Windrichtung, Temperatur, Luftfeuchtigkeit, Luftdruck, elektrische Feldstärke, magnetische Feldstärke und/oder elektromagnetische Feldstärke. Bei dieser Ausgestaltungsform ist es vorgesehen, dass die aktuellen Umweltparameter der Atmosphäre erfasst werden, insbesondere der Umgebung der erfassenden Windenergielage. Aus den oder die erfassten Werte(n) für den Umweltparameter kann/können dann ein aktueller Zustand für eine aktuelle Wetterlage ermittelt werden, insbesondere ein aktueller Wetterzustand der Atmosphäre, aus dem dann unter Verwendung bekannter physikalischer Regeln für die Wettervorhersage ein Zustand der Atmosphäre für die Zukunft, insbesondere für einen Blitzeinschlag oder Blitzwarnung, abgeleitet bzw. vorhergesagt werden können. Beispielsweise ist es hierbei auch vorgesehen, dass die Umweltparameter über einen längeren Zeitraum erfasst und immer wieder mit den Vorhersagen, insbesondere den vorhergesagten Umweltparametern, verglichen und ggf. korrigiert werden. Aus der zeitlichen Entwicklung der Umweltparameter, also der Historie der erfassten Umweltparameter, lässt sich dann eine Vorhersage für die zukünftige Entwicklung des erfassten Umweltparameters ermitteln.

Eine bevorzugte Weiterbildung sieht vor, dass der mindestens eine Wert für den Umweltparameter mit einem Referenzwert verglichen wird. Bei dieser Ausgestaltungsform ist es vorgesehen, dass die erfassten Umweltparameter mit Referenzwerten verglichen werden. Als Referenzwerte können beispielsweise Erfahrungswerte aus der Wetterforschung, insbesondere Erfahrungswerte für das Auftreten eines Blitzeinschlages, dienen. Beispielsweise kann beim Vorliegen eines bestimmten Luftdrucks, einer bestimmten Luftfeuchtigkeit und einer bestimmten Feldstärke des elektrischen Feldes auf eine Gewitterlage, insbesondere auf einen möglichen Blitzeinschlag, geschlossen werden. Ein kritischer Wert für die elektrische Feldstärke für das sehr wahrscheinliche Auftreten eines Blitzes ist bei Normaldruck (p = 101.325 Pa = 101.325 N/m²) und Normaltemperatur (T = 0°C) eine Feldstärke von ca. 3.000 kV/m. Abhängig von anderen Umweltparametern, wie z. B. Windstärke, Temperatur, Luftfeuchtigkeit und/oder Luftdruck kann es aber auch bereits bei kleineren Feldstärken, im Bereich von 300 bis 400 kV/m zu einem Durchschlagen eines Blitzes kommen. Ein weiterer Faktor bzw. Auslöser für einen Blitz ist das Vorliegen von hochenergetischen Elektronen aus der kosmischen Strahlung, die einen Blitz auch schon bei Feldstärken von 150 bis 300 kV/m auslösen können. Ein möglicher Referenzwert für die elektrische Feldstärkte ist also 150 kV/m sein, bei dem eine signifikante Gefahr für einen Blitzeinschlag besteht.

Bei einer vorteilhaften Ausgestaltung kann es vorgesehen sein, dass beim Auswerten der Karte ein Minimalwert, ein Maximalwert und/oder ein Gradient ermittelt werden. Diese Ausgestaltungsform erlaubt es in einfacher Art und Weise, die Extrema der aktuellen Wetterlage in der Windparkanlage zu ermitteln. Beispielsweise schlägt ein Blitz bevorzugt in der Windenergieanlage ein, bei der das elektromagnetische Feld am stärksten ist. Daneben kann aber auch die Luftfeuchtigkeit eine Rolle spielen. Bei der Auswertung und der Vorhersage werden dann beide Umweltparameter berücksichtigt, insbesondere deren Maximal- und Minimalwerte. Auch ist es bei der Bestimmung von Minimal- und/oder Maximalwerten relativ einfach extreme Witterungsbedingungen, beispielsweise starke Windböen oder Windfronten, zu erkennen. Insbesondere zeitliche Wetteränderungen lassen sich über die Erfassung von zeitlichen Änderungen der Minimal- und Maximalwerte der Umweltparameter gut erkennen. Auch ein Gradient, als Maß für die Richtung des steilsten Anstieges oder Änderung eines Umweltparameters, kann ermittelt werden.

Eine bevorzugte Weiterbildung sieht vor, dass mit jeder Sensoranordnung der Mehrzahl der Windenergieanlagen mehrere Werte für die Umweltparameter erfasst werden und mit den mehreren Werten für die Umweltparameter mehrere Karten erstellt und ausgewertet werden. Hierbei ist es in besonderer Weise vorgesehen, dass nicht nur ein Umweltparameterwert, beispielsweise die Windstärke, sondern mehrere Umweltparameter, beispielsweise Windstärke, Windrichtung, Temperatur, Luftfeuchtigkeit, Luftdruck und Feldstärke eines elektrischen, magnetischen und/oder elektromagnetischen Feldes, erfasst werden. Insbesondere die Kombination aus Windrichtung und Feldstärke erlaubt eine gute Vorhersage darüber, in welcher Richtung und wie schnell sich eine Feldstärkenverteilung entwickelt.

Eine Weiterbildung kann vorsehen, dass mehrere Karten miteinander kombiniert werden. Insbesondere die Kombination aus verschiedenen Werten für die Umweltparameter erlaubt eine verbesserte Vorhersage für eine bestimmte Witterungsbedingung, insbesondere für eine Gewitter- oder Blitzvorhersage.

Insbesondere ist vorgesehen, dass jede der Mehrzahl der Windenergieanlagen des Windparks eine Sensoranordnung zur Erfassung einer Mehrzahl von Umweltparametern aufweist und die Sensoranordnung jeweils umfasst: einen Sensor für Windstärke, einen Sensor für Windrichtung, einen Sensor für Temperatur, einen Sensor für Luftfeuchtigkeit, einen Sensor für Luftdruck und einen Sensor für elektrische Feldstärke. Insbesondere kann der Sensor für elektrische Feldstärke einen Sensor für magnetische Feldstärke und/oder elektromagnetische Feldstärke umfassen. Die Sensorergebnisse können auf einer oder mehreren Karten für das Gebiet der Mehrzahl der Windenergieanlagen festgehalten werden.

Aufgrund der über das Gebiet verteilten Windenergieanlagen kann für dieses Gebiet eine verlässliche Vorhersage von Blitzen, jedenfalls aber eine verlässliche Warnung vor Blitzen vorgenommen werden unter Auswertung der erstellten Karte oder Karten. Die Anzahl der gemessenen Umweltparameter auf der Gebietsfläche macht unter Auswertung der erstellten Karte oder Karten eine Angabe von Zuständen und Tendenzen für die Gebietsfläche vorteilhaft möglich.

Insbesondere kann eine Bibliothekdatenbank für eine Windenergieanlage auf der Gebietsfläche erstellt werden, welche diejenigen Umweltparamater individuell für jede Windenergieanlage auf der Gebietsfläche angibt, die dafür relevant sind, wann mit einem Blitz bei der individuellen Windenergieanlage auf der Gebietsfläche zu rechnen ist. Als Informationsbasis dient vorteilhaft eine Mehrzahl von Windenergieanlagen des Windparks von Windenergieanlagen des Windparks, zu welcher die individuelle Windenergieanlage gehört. Insbesondere kann die Bibliothekdatenbank rekonfigurierbar sein und eine Parameterübermittlung von Umweltparametern an eine Leitwarte erfolgen. Auf diese Weise ist es besonders vorteilhaft möglich, eine individuelle Erstellung einer für die Windenergieanlage relevanten Kennlinie der Umweltparameter vorzunehmen, die angibt, in welchem Bereich von Umweltparametern für diese Windenergieanlage eine Blitzwarnung auszugeben ist, insbesondere ein Blitz vorhergesagt werden kann. Dies führt zu einem hohen Maß an Verlässlichkeit einer Blitzwarnung und/oder Blitzvorhersage für diese individuelle Windenergieanlage und damit zu einem besonders verlässlichen Schutz eines Servicepersonals in Abwägung zum Aufwand bei einem Abbruch der Servicetätigkeit. Dies führt zu einer besonders vorteilhaften Nutzung einer Windenergieanlage als Station zur Blitzwarnung und/oder Blitzvorhersage; insbesondere zur Ausbildung eines besonders bevorzugten Systems zur Blitzwarnung und/oder Blitzvorhersage mit einer Anzahl von Windenergieanlagen eines Windparks. Vorzugsweise kann die Windenergieanlage als Wetterstation und/oder der Wind park als System zur Wettervorhersage genutzt werden.

Bevorzugt sieht eine Ausgestaltung vor, dass basierend auf dem Auswerten der Karten für die Standorte der Mehrzahl der Windenergieanlagen Wahrscheinlichkeiten für einen Blitzschlag, insbesondere für einen Blitzeinschlag in einer bestimmten Windenergieanlage, zugeordnet werden. Hierbei ist es insbesondere vorgesehen, die aktuell erfassten Umweltparameter, insbesondere Windstärke, Windrichtung, Temperatur, Luftfeuchtigkeit, Luftdruck und Feldstärke eines elektrischen, magnetischen und/oder elektromagnetischen Feldes an einer bestimmten Windenergieanlage oder für eine bestimmten Standort der Windenergieanlage auszuwerten und zu bewerten, derart, dass eine Wahrscheinlichkeit für eine Blitzeinschlag ermittelt wird und der Windenergieanlage oder dem Standort der Windenergieanlage zugeordnet. Auch ist es möglich hierfür eine zeitliche Entwicklung der erfassten Umweltparameter zu berücksichtigen. Beispielsweise erhöht sich die Wahrscheinlichkeit für einen Blitzeinschlagt, wenn die Feldstärke eines elektrischen, magnetischen und/oder elektromagnetischen Feldes in kurzer Zeit stark ansteigt. Für die Ermittlung der Wahrscheinlichkeiten können beispielweise auf Standartmodell und/oder Erfahrungswerte aus der Wetterforschung/Wettervorhersage zurück-gegriffen werden.

Eine bevorzugte Ausgestaltungsform betrifft ein Verfahren, bei dem die ermittelten Wahrscheinlichkeiten für einen Blitzeinschlag mit Grenzwahrscheinlichkeiten verglichen werden und eine Blitzwarnung für einen Standort der Mehrzahl der Windenergieanlagen ausgegeben wird, bei denen die Wahrscheinlichkeit für einen Blitzeinschlag die Grenzwahrscheinlichkeit übersteigt. Insbesondere, wenn die Wahrscheinlichkeit für einen Blitzeinschlag größer 50%, bevorzugt größer 70% und noch mehr bevorzugt größer 90% ist, wird eine Blitzwarnung für den entsprechenden Standort der Windenergieanlagen oder die mehreren Standorte ausgegeben.

Eine vorteilhafte Ausgestaltungsform betrifft ein Verfahren, bei dem die Blitzwarnung in Form einer Warnmitteilung, insbesondere für die bestimmte Windenergieanlage der Mehrzahl der Windenergieanlagen, ausgegeben wird, wobei die Warnmitteilung als eine akustische Durchsage und/oder in Form einer Warnleuchte ausgegeben werden kann. Hierbei ist es vorgesehen - im Falle einer Blitzwarnung - diese in Form einer automatische Warnmeldung, beispielsweise über Lautsprecher im Inneren des Turmes ausgegeben wird, sodass das Wartungspersonal gewarnt wird und mögliche Wartungsarbeiten abbrechen kann. Auch kann es vorgesehen sein, dass eine Warnleuchte automatisch eingeschaltet wird, die dann vor einem möglichen Blitzeinschlag warnt. Auch kann es vorgesehen sein, dass im Falle einer Blitzwarnung die entsprechende Windenergieanlage automatisch abgeschaltet wird.

Ein im Rahmen einer besonders bevorzugten Weiterbildung des Verfahrens benutztes meteorologisches Modell sieht vor, dass nicht nur ein elektrisches Feld, sondern auch weitere Umweltparameter wie die oben genannte Windstärke, Windrichtung, Temperatur, Luftfeuchtigkeit genutzt werden, um eine Blitzwarnung, insbesondere eine Blitzvorhersage, möglich zu machen. Das meteorologische Modell für die Nutzung eines Elektrofeldmeters zum Erfassen von elektrischen Feldstärken basiert im einfachsten Fall auf dem folgenden physikalischen Mechanismus einer Blitzentstehung. Der physikalische Mechanismus sieht im einfachsten Fall, jedoch nicht beschränkt darauf, das Zusammenströmen von warmen, feuchten Luftmassen vor, die, wenn sie aufsteigen, Wasserdampf auskondensieren und unter gewissen äußeren Bedingungen eine sich auftürmende Haufenwolke bilden. Je höher eine solche Haufenwolke ist, desto höher ist die Wahrscheinlichkeit, dass sich in ihrem Inneren Ladungen durch Reibung und Zerstäuben von Wasserteilchen bilden. Dies ist insbesondere dann der Fall, wenn sich im oberen kälteren Teil der Haufenwolke Eiskristalle positiv aufladen und im unteren Teil der Haufenwolke Tropfen negativ aufladen. Eine solche im oberen Teil einer Haufenwolke überwiegende positive Ladung kann zu einer im unteren Teil der Haufenwolke überwiegende negative Ladung je nach Höhe der Haufenwolke (bis zu einigen Kilometern) elektrische Felder anwachsen lassen, die zu Spannungen über mehrere Hundert Millionen Volt führen.

Eine Entladung dieser Ladungstrennung zunächst innerhalb der Wolke kann zu einem sogenannten Leitblitz in Richtung Boden führen, der gegebenenfalls unter Bildung einer Fangentladung am Boden oder an exponierten Stellen am Boden, beispielsweise einer Windenergieanlage, zur Ausbildung eines ionisierten Blitzkanals führen, dem anschließend die Hauptentladung - der eigentliche Blitz - folgt. Bereits auf Basis dieses vergleichsweise einfachen physikalischen Mechanismus hat die Weiterbildung erkannt, dass ein zugrunde zu legendendes meteorologisches Verfahren zur Blitzwarnung, insbesondere Blitzvorhersage, um so verlässlicher ist, je mehr Stützpunkte zum Erfassen von elektrischen Feldern vorliegen. Die Weiterbildung sieht deswegen mit Vorteil eine zunehmende Anzahl von Windenergieanlagen eines Windparks, jedenfalls aber eines Teils eines Windparks mit einer Auswahl von Windenergieanlagen (beispielsweise die an den Rändern des Windparks vorgesehen Windenergieanlagen und eine Verteilung von Windenergieanlagen innerhalb des Gebiets des Windparks) vor, um Stützstellen zur Messung von elektrischen Feldern zu ermöglichen. Vorteilhaft können dies alle Windenergieanlagen eines Windparks sein. Vorteilhaft wird bei jeder der Windenergieanlagen, jedenfalls aber bei den oben genannten Stützstellen bildenden Windenergieanlagen, die Messung der vorgenannten Umweltparameter vorgenommen.

Im Folgenden soll nun - ohne die Erfindung auf die konkreten Werte einzuschränken - ein konkretes Beispiel für ein Verfahren zur Blitzwarnung mit einer Anzahl i von Windenergieanlagen, insbesondere mit einem Teil eines Windparks, beschrieben werden. Die Anzahl i der Windenergieanlagen, wobei i einen Wert von 1, 2, ... n annehmen kann, sind dabei an unterschiedlichen Standorten stationiert, wobei jede der Windenergieanlagen eine Sensoranordnung zur Erfassung eines Umweltparameters mit wenigstens einen Windmesser, einen Temperatursensor und/oder einen Feuchtigkeitssensor und einen weiteren Sensor, insbesondere einem Elektrofeldmeter, zum Erfassen von elektrischen Feldstärken, aufweist. Mit Hilfe der Sensoren werden wenigstens ein Wert für einen Umweltparameter, beispielsweise Windstärke, Windrichtung, Temperatur, Luftfeuchtigkeit, Luftdruck und/oder Feldstärke eines elektrischen Feldes erfasst, wenigstens aber die elektrische Feldstärke. Anschließend werden die erfassten Werte für den Umweltparameter zur Vorhersage eines Blitzes und Blitzwarnung für die jeweiligen Standorte der Windenergieanlagen ausgewertet. Hierbei wird berücksichtigt, dass es während eines Gewitters in den Gewitterwolken zu einer Ladungstrennung kommen kann, die dann lokal zu unterschiedlich großen elektrischen Feldstärken führt. Die elektrische Feldstärke und/oder die Verteilung der elektrischen Feldstärken kann mit Hilfe der Sensoranordnung der Anzahl i von Windenergieanlagen erfasst werden. Übersteigt die elektrische Feldstärke an einer bestimmten Windenergieanlage einen (vor-)bestimmten kritischen Wert, einen Grenzwert für ein elektrisches Feld, so wird eine Blitzwarnung für diese Windenergieanlage ausgegeben. Die kritische Feldstärke, bei der es in der Luft unter Normaldruck (p = 101.325 Pa = 101.325 N/m²) und Normaltemperatur (T = 0°C) zum Durchschlagen eines Blitzes kommt, beträgt ca. 3.000 kV/m. Abhängig von anderen Umweltparametern, wie z. B. Windstärke, Temperatur, Luftfeuchtigkeit und/oder Luftdruck kann es aber auch bereits bei kleineren Feldstärken, im Bereich von 300 bis 400 kV/m zu einem Durchschlagen eines Blitzes kommen. Ein weiterer Faktor bzw. Auslöser für einen Blitz ist das Vorliegen von hochenergetischen Elektronen aus der kosmischen Strahlung, die einen Blitz auch schon bei Feldstärken von 150 bis 300 kV/m auslösen können. Übersteigt bei Normalbedingungen (p = 101.325 Pa, T = 0°C) beispielsweise die elektrische Feldstärke an einer oder mehreren Windenergieanlage(n) einen Grenzwert von 150 kV/m, so wird eine Blitzwarnung für die eine oder die mehreren Windenergieanlage(n) ausgegeben.

Ausführungsbeispiele der Erfindung werden nachfolgend anhand der Figuren im Vergleich zum Stand der Technik, welcher zum Teil ebenfalls dargestellt ist, beschrieben. Diese sollen die Ausführungsbeispiele nicht notwendigerweise maßstäblich darstellen, vielmehr sind die Figuren, wo zur Erläuterung dienlich, in schematisierter und/oder leicht verzerrter Form ausgeführt. Im Hinblick auf Ergänzungen der aus den Figuren unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in den Figuren sowie in den Ansprüchen offenbarten Merkmale der Erfindung können sowohl einzeln als auch in beliebiger Kombination für die Weiterbildung der Erfindung wesentlich sein. Zudem fallen in den Rahmen der Erfindung alle Kombinationen aus zumindest zwei der in der Beschreibung, den Figuren und/oder den Ansprüchen offenbarten Merkmale. Die allgemeine Idee der Erfindung ist nicht beschränkt auf die exakte Form oder das Detail der im Folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei angegebenen Bemessungsbereichen sollen auch innerhalb der genannten Grenzen liegende Werte als Grenzwerte offenbart und beliebig einsetzbar und beanspruchbar sein. Identische oder ähnliche Teile oder Teile identischer oder ähnlicher Funktion sind, dort wo sinnvoll der Einfachheit halber mit einem gleichen Bezugszeichen versehen.

Weitere Vorteile, Merkmale und Einzelheiten der Erfindung ergeben sich aus der nachfolgenden Beschreibung der bevorzugten Ausführungsbeispiele sowie anhand der Figuren.

Im Einzelnen zeigen:
- Fig. 1: eine mögliche Ausgestaltungsform für eine Windenergieanlage;
- Fig. 2: eine mögliche Ausgestaltungsform für eine Sensoranordnung;
- Fig.3: eine mögliche Ausgestaltungsform für einen Windpark;
- Fig. 4: eine mögliche Ausgestaltungsform für ein Verfahren zur Gewitter-, insbesondere Blitzwarnung, mit einer Mehrzahl von Windenergieanlagen;
- Fig. 5: eine mögliche Ausgestaltungsform einer Karte für die Standorte der Mehrzahl der Windenergieanlagen und einen Wert für eine Umweltparameter;
- Fig. 6: eine weitere Ausgestaltungsform einer Karte für die Standorte der Mehrzahl der Windenergieanlagen und die Stärke eines elektromagnetischen Feldes als erfassten Umweltparameter;
- Fig.7: eine andere Ausgestaltungsform einer Karte für die Standorte der Mehrzahl der Windenergieanlagen und der Windstärke als erfassten Umweltparameter;
- Fig. 8: wiederum eine andere Ausgestaltungsform einer Karte für die Standorte der Mehrzahl der Windenergieanlagen und einer Kombination aus Feld- und Windstärke als erfasste Umweltparameter; und
- Fig. 9: eine mögliche Ausgestaltungsform für ein System zur Wettervorhersage, insbesondere zur Blitzwarnung.

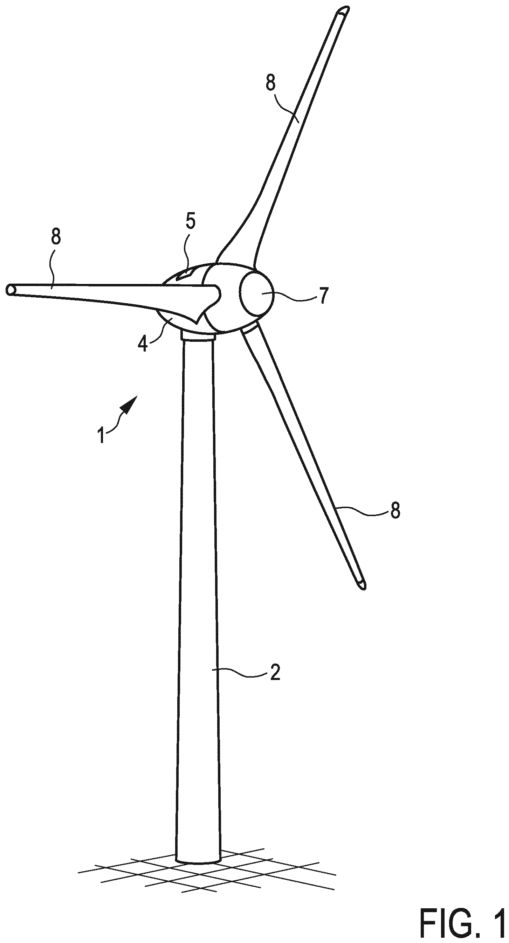

Fig. 1 zeigt eine Windenergieanlage 1 mit einem Turm 2 und einer Gondel 4. An der Gondel 4 ist ein Rotor 6 mit drei Rotorblättern 8 und einem Spinner 7 angeordnet. Der Rotor wird im Betrieb der Windenergieanlage 1 durch den Wind in eine Drehbewegung versetzt und treibt einen Generator (nicht dargestellt) im Inneren der Gondel 4 an. Mit Hilfe des Generators wird die mechanische Energie der Drehbewegung in elektrische Energie gewandelt und anschließend ins Stromnetz eingespeist.

Weiterhin umfasst die Windenergieanlage 1 eine Sensoranordnung 5 zum Erfassen von mindestens einem Umweltparameter, beispielsweise Windstärke, Windrichtung, Temperatur, Luftfeuchtigkeit, Luftdruck und/oder elektrische, magnetische und/oder elektromagnetischen Felder in der Atmosphäre. Die Sensoranordnung 5 umfasst hierfür insbesondere einen Windmesser, einen Temperatursensor, einen Feuchtigkeitssensor, ein Barometer oder Drucksensor und/oder einen weiteren Sensor, insbesondere Elektrofeldmeter, zum Erfassen von elektrischen, magnetischen und/oder elektromagnetischen Felder oder Feldstärken.

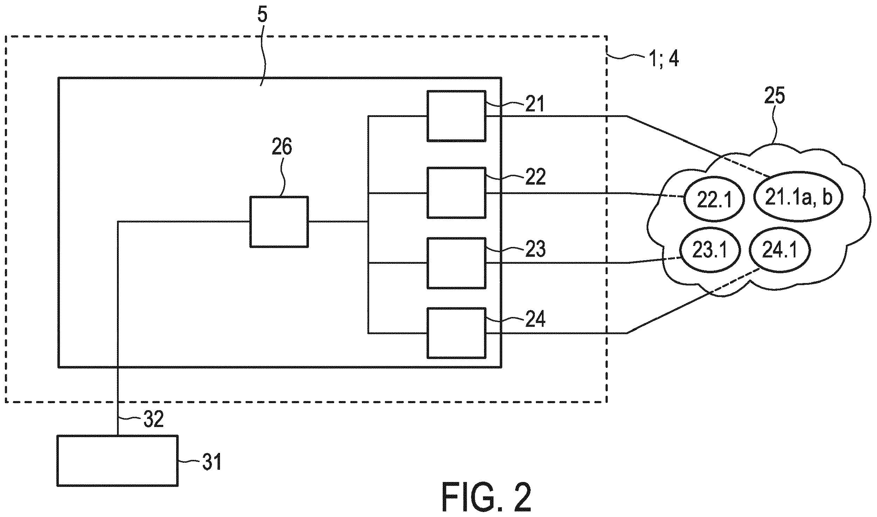

Fig. 2 zeigt eine mögliche Ausgestaltungsform einer Sensoranordnung 5 zur Erfassung von Umweltparametern 25, wobei die Sensoranordnung 5 an einer Windenergieanlage 1, insbesondere auf dem Dach der der Gondel 4 der Windenergieanlage 1 (schematisch dargestellt), angeordnet ist. Darüberhinaus steht die Windenergieanlage 1, insbesondere die Sensoranordnung 5, über eine Verbindungsleitung 32 mit einem Server 31, insbesondere mit einem Server eines Windparks, in Verbindung, so dass beispielsweise die mit der Sensoranordnung 5 der Windenergieanlage 1 erfassten Umweltparameter 25 an den Server 31 geleitet werden können.

Die Sensoranordnung 5 umfasst - ohne Einschränkung auf die konkret genannten Sensoren - beispielsweise einen Windmesser 21, einen Temperatursensor 22, einen Feuchtigkeitssensor 23 und/oder einen weiteren Sensor 24, insbesondere Elektrofeldmeter, zum Erfassen von elektrischen, magnetischen und/oder elektromagnetischen Feldstärken in der Atmosphäre. Auch kann die Sensoranordnung 5 noch weitere Sensoren aufweisen, beispielsweise ein Barometer oder Drucksensor zur Erfassung des Luftdrucks in der Atmosphäre.

Mit den jeweiligen Sensoren der Sensoranordnung 5 können dann ein oder mehrere Umweltparameter 25 wie z. B. Windstärke 21.1a, Windrichtung 21.1b, Temperatur 22.1, Luftfeuchtigkeit 23.1 und/oder elektrische Feldstärke 24.1 eines elektrischen Feldes in der Atmosphäre erfasst werden. Die jeweiligen Sensoren stehen vorliegend mit einem zentralen Steuerelement 26 der Sensoranordnung 5 in Verbindung, welche die Steuerung und/oder Auswertung der einzelnen Sensoren übernehmen kann. Alternativ können aber auch die einzelnen Sensoren eine eigene Steuereinheit umfassen, die dann beispielsweise in dem jeweiligen Sensor integriert ist, so dass die einzelnen Sensoren auch "autark" von der Sensoranordnung 5 eingesetzt werden können. Die erfassten Werte für die Umweltparameter 25 können entweder in der Steuereinheit 26, die dann auch als Auswerteeinheit dient, oder aber im Sever 31 ausgewertet werden, in dem sie beispielsweise mit Grenz- oder Referenzwerten verglichen werden. Übersteigt ein erfasster Wert für einen Umweltparameter 25 beispielsweise einen Grenzwerte, kann eine Warnmeldung, insbesondere eine Blitzwarnung ausgegeben werden. Bevorzugt werden die erfassten Werte für die Umweltparameter 25 an den Server weitergeleitet und dort zentral für mehrere Windenergieanlagen ausgewertet. Die Verbindungsleitung 32 dient hierbei als Kommunikationsleitung zwischen der Windenergieanlage 1 und dem Sever 31.

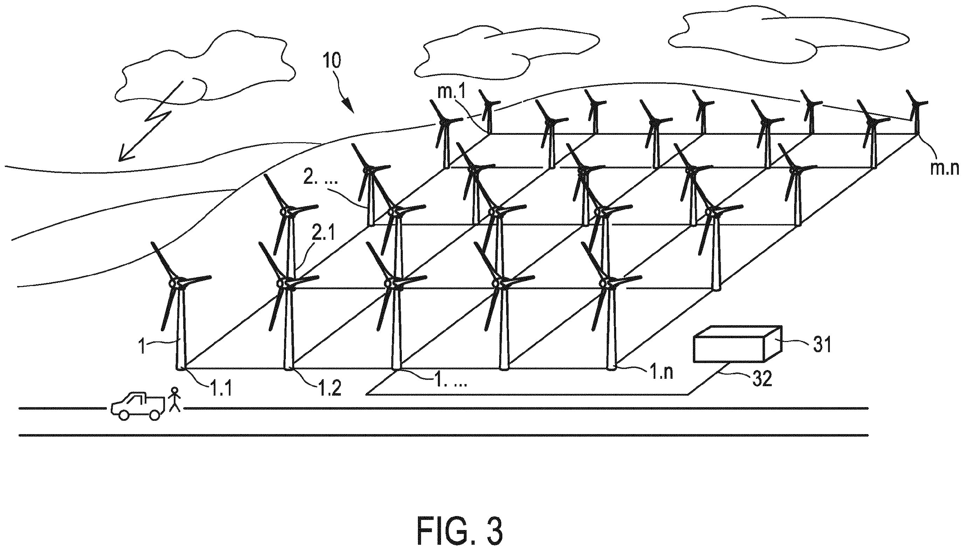

Fig. 3 zeigt eine mögliche Ausgestaltungsform für einen Windpark 10 aus einer Mehrzahl von Windenergieanlagen 1, insbesondere aus n ^{∗} m Windenergieanlagen 1, wobei die einzelnen Windenergieanlagen 1 jeweils an einem bestimmten Standort 1.1, 1.2, ..., m.n angeordnet sind. Bei den Standorten kann es sich beispielsweise um Koordinaten eines beliebigen Koordinatensystems für die Windenergieanlagen handeln oder aber auch um individuelle (Serien-)Nummern, die dann jeweils einer bestimmten Windenergieanlage 1 zugeordnet sind. Alternativ oder ergänzend können die Standorte auch GPS-Informationen über den tatsächlichen Standort der jeweiligen Windenergieanlage 1 enthalten.

Vorliegend umfasst jede der Mehrzahl der Windenergieanlagen 1 eine Sensoranordnung, wie sie beispielsweise in der Fig. 2 dargestellt und beschrieben ist und mit welcher Umweltparameter, wie z.B. Windstärke, Windrichtung, Temperatur, Luftdruck, Luftfeuchtigkeit und/oder ein elektromagnetisches Feld, erfasst werden können.

Darüber ist ein Server 31 vorgesehen, der über Verbindungsleitung 32 mit den einzelnen Windenergieanlagen 1 der Mehrzahl von Windenergieanlagen in Verbindung steht, so dass die mit einer bestimmten Windenergieanlagen 1, insbesondere der Sensoranordnung der bestimmten Windenergieanlagen 1, erfassten Umweltparameter an den Server 31 weitergeleitet werden können. Hierbei sendet jede Windenergieanlage 1 zusammen mit den erfassten Umweltparametern auch Informationen über ihren Standort 1.1, 1.2, ..., m.n an den Server 31 weiter, so dass eine genaue Zuordnung zwischen dem erfassten Umweltparameter und einer bestimmten Windenergieanlage im Server möglich ist.

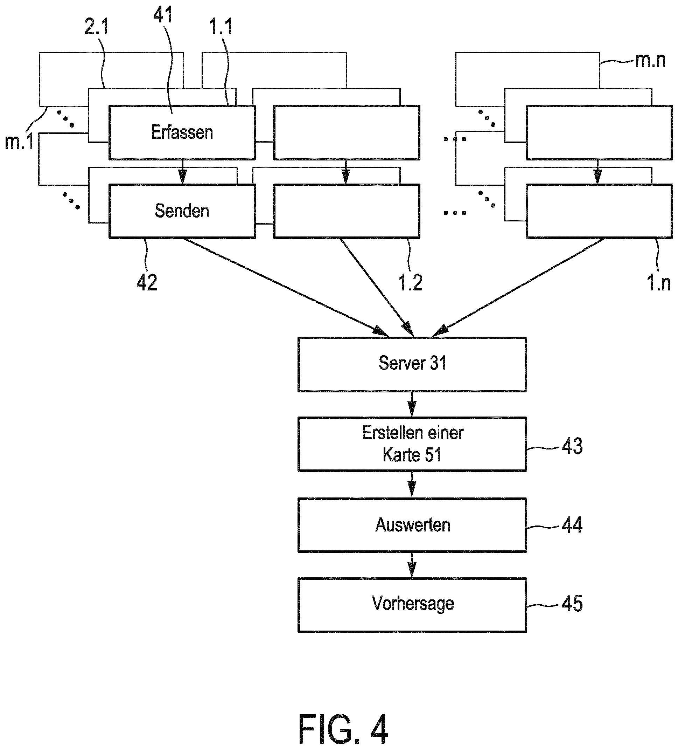

Fig. 4 zeigt eine schematische Darstellung für eine mögliche Ausgestaltungsform für ein Verfahren zur Blitzwarnung mit einer Mehrzahl von Windenergieanlagen.

Hierbei werden beispielsweise mit einer Mehrzahl von Windenergieanlagen, insbesondere mit den Windenergieanlagen eines Windparks mit n ^{∗} m Windenergieanlagen, nämlich einer Windenergieanlage am Standort 1.1, einer Windenergieanlage am Standort 1.2, einer Windenergieanlage am Standort 1.3, usw. und schließlich mit einer Windenergieanlage am Standort m.n jeweils ein oder mehrere Umweltparameter, insbesondere Windstärke, Windrichtung, Temperatur, Luftdruck, Luftfeuchtigkeit und/oder ein elektrisches Feld, erfasst 41 und dann von den jeweiligen Windenergieanlagen an einen Server 31, insbesondere an einem Server des Windparks, gesendet 42 oder weitergeleitet. Hierbei dienen die einzelnen Windenergieanlage mit Ihren Sensoranordnungen an ihren jeweiligen Standorten 1.1 bis m.n als (Wetter-)Messstation für die verschiedenen Umweltparametern, wie z.B. Windstärke, Windrichtung, Temperatur, Luftfeuchtigkeit, Luftdruck und/oder elektrische Felder in der Atmosphäre.

Anschließend wird im Server 31 aus den erfassten Umweltparametern zusammen mit den Standorten eine oder mehrere Karte(n) 51 erstellt 43, in welcher die erfassten Werte gemappt, also graphisch dargestellt werden. Ohne Einschränkung der vorliegenden Erfindung können hierbei verschiedene Darstellungsarten verwendet werden um die erfassten Daten zu visualisieren. Auch kann es vorgestehen sein, für das Auswerten 44 der erfassten Umweltparameter ganz auf eine graphische Darstellung verzichtet, wobei dann lediglich die Zahlenwerte, beispielsweis in Form von Tabellen und/oder anderen Datensätzen für die Umweltparameter ausgewertet werden.

Bevorzugt wird eine Karte für die Standorte der Mehrzahl der Windenergieanlagen und für einen oder mehrere erfasste Werte von Umweltparameter erstellt 43 und zur Vorhersage 45 einer Blitzwarnung für einen oder mehrere Standorte der Mehrzahl der Windenergieanlagen ausgewertet 44.

Für die Auswertung 44 der erfassten Umweltparameter können diese erfassten Werte beispielsweise mit Hilfe von Standardmodellen, wie sie für die Wetterforschung und Wettervorhersage bekannt sind, ausgewertet werden. Basierend hierauf kann dann ein Auswerteergebnis für die Vorhersage, insbesondere für einen Blitzeinschlag und eine Blitzwarnung, ermittelt und ausgegeben werden.

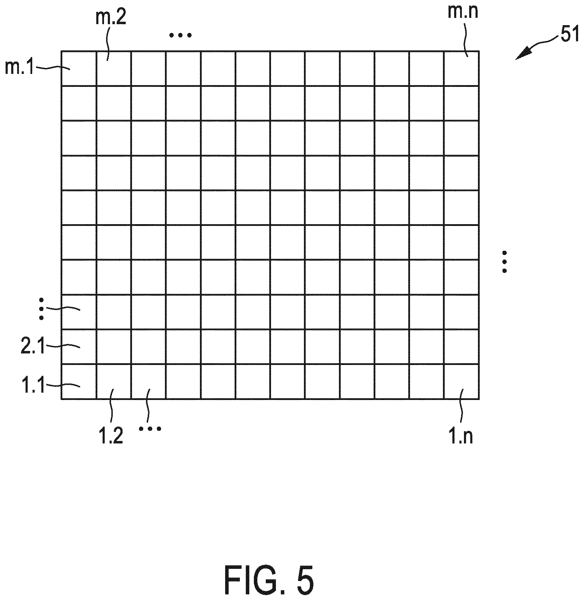

Fig. 5 zeigt eine mögliche Ausgestaltungsform einer Karte für die Standorte 1.1 bis m.n der Mehrzahl der Windenergieanlagen. Vorliegend umfasst die Karte n^{∗}m Pixel, also m Reihen und n Spalten, wobei jedem Pixel eine bestimmte Windenergieanlage, insbesondere der Standort einer bestimmten Windenergieanlage, des Windparks zugeordnet werden kann. Jedes Pixel der Karte 51 umfasst also immer mindestens zwei Informationen, nämlich einmal einen Wert für einen Umweltparameter, beispielsweise Windstärke, Windrichtung, Temperatur, Luftfeuchtigkeit, Luftdruck und/oder elektrische Feldstärke, und ein anderes Mal eine Information über den Standort der Windenergieanlage, beispielsweise eine GPS-Information oder dergleichen, mit welcher der jeweilige Umweltparameter (des Pixels der Karte) erfasst wurde. Ohne Einschränkung können auch andere Ausgestaltungsformen für Karten erstellt werden, die dann entsprechend konfiguriert sind, die Standortinformationen der Windenergieanlage des Windparks korrekt abzubilden. Beispielsweise können unterschiedlich große Pixel und/oder Pixelformen vorgesehen sein. Je nach dem wie die Windenergieanlagen im Windpark verteilt oder angeordnet sind oder wie die tatsächliche Form des Windparks ist, werden die Karten entsprechend angepasst. Vorliegend - aber ohne die Erfindung auf diese konkrete Ausgestaltung einzuschränken - gehört die Karte zu einem rechteckigen Windpark mit n^{∗}m Windenergieanlagen, wie er beispielsweise in der Fig. 3 dargestellt und beschrieben ist.

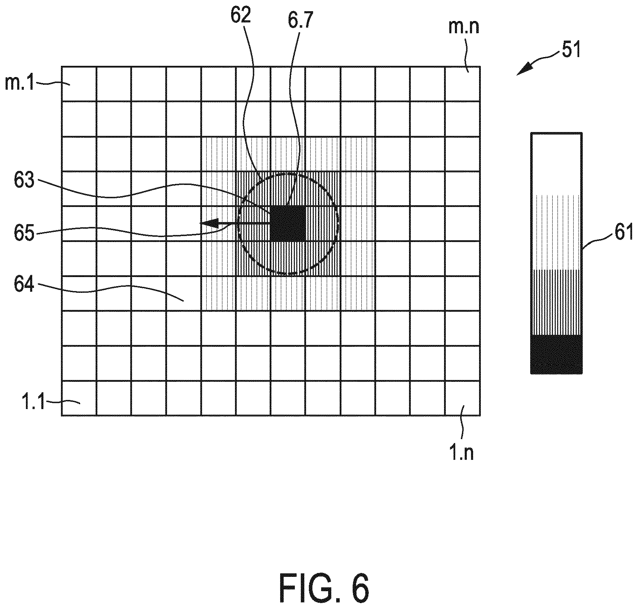

Fig. 6 zeigt eine mögliche Ausgestaltungsform für eine erstellte Karte - wie sie in der Fig. 5 beschrieben ist - für die Standorte der Mehrzahl der Windenergieanlagen und die (Feld)Stärke eines elektrischen Feldes als erfassten Umweltparameter. Vorliegend wird die Stärke des elektrischen Feldes in Form einer Farbskala 61 von schwarz nach weiß dargestellt, wobei schwarz ein starkes elektrisches Feld und weiß ein schwaches elektrisches Feld repräsentiert. Ohne Einschränkung können auch andere Farbskalen und/oder andere Skalenformen verwendet werden, die konfiguriert sind, unterschiedliche Feldstärken graphisch darzustellen. Hierbei können die Skalen bzw. die graphische Darstellung beispielswiese auch relativ (zu einem Maximal- 63 oder Minimalwert 64) oder absolut gewählt sein. Auch eine logarithmische Darstellung kann vorgesehen sein. Vorliegend zeigen die weißen Pixel die Minimalwerte 64 und die/das schwarze(n) Pixel die/den Maximalwert(e) für die Stärke des elektrischen Feldes. Auch ist es beispielsweise möglich einen Gradienten 65, als Richtungsmaß für den steilsten Anstieg für das elektrische Feld zu ermitteln und anzuzeigen (Pfeil).

Vorliegend ist eine Verteilung der Feldstärke für ein elektrisches Feld für die einzelnen Windenergieanlagen/Standorte eines Windparks gezeigt, wobei die Werte für die Stärke des elektrischen Feldes mit Hilfe der jeweiligen Sensoranordnung der einzelnen Windenergieanlagen erfasst und an einen Server weitergeleitet wurden. Anschließend wird im Sever aus den erfassten Umweltparametern, vorliegend der Feldstärke, zusammen mit den Standorten eine Karte 51 erstellt, in welcher die erfassten Werte gemappt, also graphisch dargestellt sind. Die dargestellte erfasste Verteilung der elektrischen Feldstärke hat einen Maximalwert 63 bei/in dem Pixel 6.7. Demnach ist das elektrische Feld bei der Windenergiealge am Standort 6.7 am stärksten. Hier ist die Wahrscheinlichkeit für eine atmosphärische Entladung in Form eines Blitzeinschlages am größten.

Übersteigt die elektrische Feldstärke einen bestimmten Grenzwert, beispielsweise 150 kV/m, und damit eine bestimmte Grenzwahrscheinlichkeit für einen Blitzeinschlag, so wird von einem möglichen Blitzschlag in dieser Windenergieanlage ausgegangen und eine Blitzwarnung an die entsprechende Windenergieanlage ausgegeben. Auch kann es vorgesehen sein, dass eine Blitzwarnung an mehrere Windenergieanlagen in einen bestimmten Bereich 62 um die entsprechende Windenergieanlage, insbesondere an benachbarte Windenergieanlagen, ausgegeben wird.

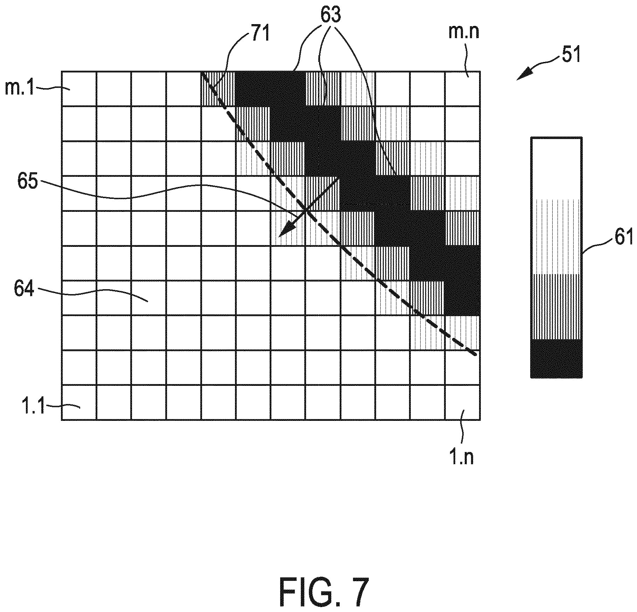

Fig. 7 zeigt eine weitere Ausgestaltungsform für eine erstellte Karte - wie sie in der Fig. 5 beschrieben ist - für die Standorte 1.1 bis m.n der Mehrzahl der Windenergieanlagen eines Windparks und der Windstärke als erfassten Umweltparameter. Ähnlich wie in der Fig. 6 wird vorliegend die Stärke des Windes in Form einer Farbskala dargestellt, wobei hohe Windstärken oder hohe Windgeschwindigkeiten mit schwarz und geringe Windstärken mit weiß gekennzeichnet sind. In der vorliegend gezeigten Karte 51 ist eine Windstärkenverteilung zu erkennen, die mehrere Maximalwerte 63 in Form eines länglichen Maximums aufweist. Hierbei handelt es sich um eine Windfront 71, die sich über den Windpark bewegt.

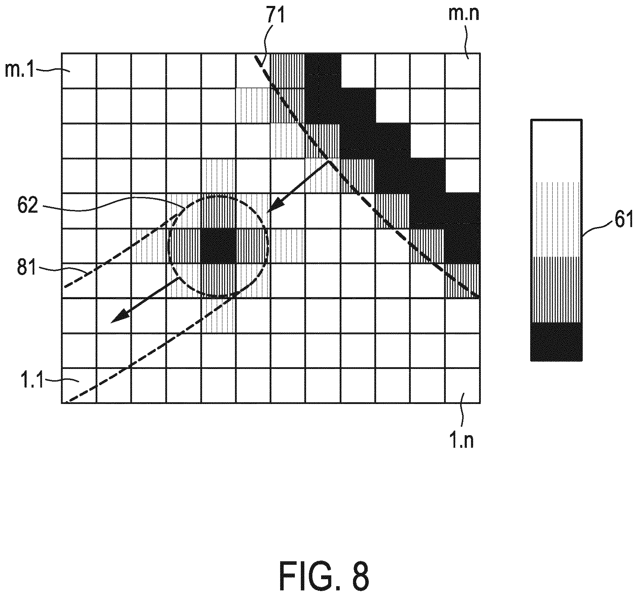

Fig. 8 zeigt eine weitere Ausgestaltungsform für eine Karte 51, wobei hierbei zwei erfasste Umweltparameter, nämlich die elektrische Feldstärke und Windstärke, wie sie beispielweise in den Fig. 6 und 7 dargestellt und beschrieben sind, zusammen in einer Karte dargestellt werden.

Vorliegend ist eine Windfront 71 gezeigt, die eine elektrische Feldverteilung, insbesondere die Wolken mit den Ladungstrennungen, vor sich her treibt. Aus der kombinierten Darstellung von elektrischem Feld und Windstärke kann beispielsweise eine Blitzeinschlagvorhersage für einen bestimmten Bereich 62 und eine zeitliche Entwicklung 81 des Bereiches 62 ermittelt werden, in welchem die Windenergieanlagen stationiert sind, bei denen ein Blitzeinschlag befürchtet wird, so dass an diese - potentiell gefährdeten - Windenergieanlagen eine Blitzwarnung ausgegeben werden kann.

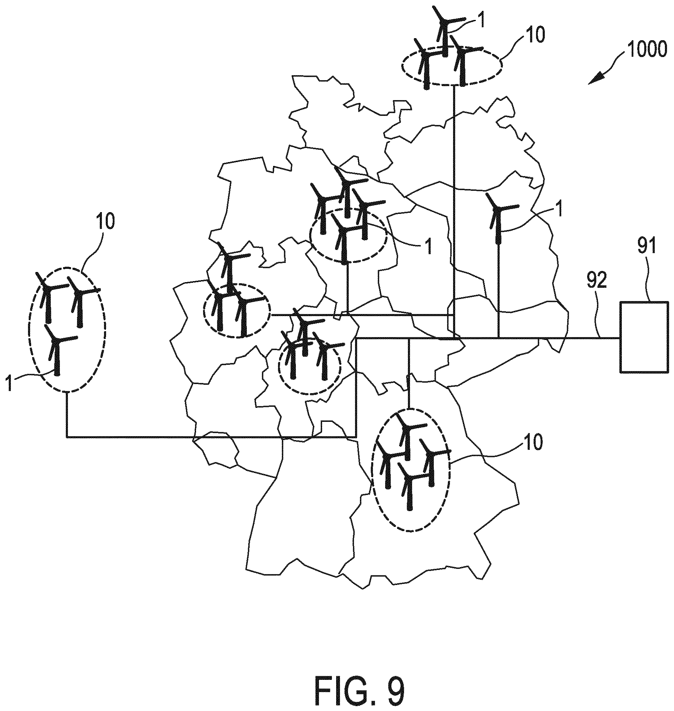

Fig. 9 zeigt eine mögliche Ausgestaltungsform für ein System 1000 zur Wettervorhersage, insbesondere zur Blitzwarnung. Hierbei können viele verschiedene Windparkanlagen, beispielsweise auch Offshore-Windparks, oder einzelne Windenergieanlagen miteinander über ein Verbindungnetzwerk 92 vernetzt werden und mit einen gemeinsamen, zentralen Server 91 verbunden sein. Auch ist es vorstellbar, dass die Server einzelner Windparks (vgl. z. B. Server 31 in der Fig. 3) mit dem gemeinsamen, zentralen Server 91 verbunden sind. Mit den jeweiligen Windparks und/oder Windenergieanlagen können dann Umweltparameter über einen großen Bereich hinweg an verschiedenen Ort erfasst und an den zentralen Server 91 weitergeleitet werden. In dem gemeinsamen, zentralen Server 91 können die erfassten Umweltparameter dann zur Wettervorhersage, insbesondere für die Gewitter- und/oder Blitzwarnung, ausgewertet werden.

## Patentansprüche

1. Verfahren zur Blitzwarnung mit einem System einer Mehrzahl von Windenergieanlagen (1) wobei die Windenergieanlagen (1) jeweils an einem Standort (1.1, 1.2, ... , m.n) stehen und jede der Mehrzahl von Windenergieanlagen (1) eine Sensoranordnung (5) zur Erfassung eines Umweltparameters aufweist, umfassend wenigstens einen Windmesser (21), einen Temperatursensor (22) und/oder einen Feuchtigkeitssensor (23), wobei die Sensoranordnung (5) einen weiteren Sensor (24), nämlich ein Elektrofeldmeter, zum Erfassen von elektrischen Feldern aufweist, und das Verfahren die folgenden Schritte umfasst:
- Erfassen (41) von mindestens einem Wert für den Umweltparameter (25), wenigstens umfassend ein elektrisches Feld, mit Hilfe der Sensoren (21, 22, 23, 24) der Sensoranordnung (5) mit der Mehrzahl der Windenergieanlagen (1); und
- Auswerten (44) des mindestens einen Wertes für den Umweltparameter zur Vorhersage (45) der Blitzwarnung (1) für die Standorte (1.1, 1.2, ... , m.n) der Mehrzahl der Windenergieanlagen (1), **dadurch gekennzeichnet, dass**
- in dem System die Mehrzahl der Windenergieanlagen (1) mit einem gemeinsamen zentralen Server (91) in Verbindung stehen,
wobei das Verfahren weiter die folgenden Schritte umfasst:
- Senden (42) des mindestens einen Wertes für den Umweltparameter (25) von der Mehrzahl der Windenergieanlagen (1) zum Server (31);
- Erstellen (43) einer Karte (51) mit dem mindestens einen Wert für den Umweltparameter (25) und den Standort (1.1, 1.2, ... , m.n) der Mehrzahl der Windenergieanlagen (1); und
- Auswerten (44) der Karte (51) zur Vorhersage (45) der Blitzwarnung (1) für die Standorte (1.1, 1.2, ... , m.n) der Mehrzahl der Windenergieanlagen (1), wobei
- mit jeder Sensoranordnung (5) der Mehrzahl der Windenergieanlagen (1) mehrere Werte für den Umweltparameter (25) erfasst werden, und mit den mehreren Werten für den Umweltparameter mehrere Karten (51) erstellt und ausgewertet werden, und die mehreren Karten (25) miteinander kombiniert werden, wobei
- basierend auf dem Auswerten der mehreren Karten (51) den Standorten (1.1, 1.2, ... , m.n) der Mehrzahl der Windenergieanlagen (1) Wahrscheinlichkeiten für einen Blitzeinschlag zugeordnet werden, wobei für die Ermittlung der Wahrscheinlichkeiten auf Standardmodelle und/oder Erfahrungswerte aus der Wettervorhersage zurückgegriffen wird, wobei
- die mehreren Werte für den Umweltparameter (25) aus der folgenden Gruppe von Werten ausgewählt sind: Windstärke (21.1a), Windrichtung (21.1b), Temperatur (22.1), Luftfeuchtigkeit (23.1), Luftdruck, elektrische Feldstärke (24.1), magnetische Feldstärke und elektromagnetische Feldstärke, und
- die Wahrscheinlichkeiten für einen Blitzeinschlag mit Grenzwahrscheinlichkeiten verglichen werden und eine Blitzwarnung für diejenigen Standorte (1.1, 1.2, ... , m.n) der Mehrzahl der Windenergieanlagen (1) ausgegeben wird, bei denen die Wahrscheinlichkeit für den Blitzeinschlag die Grenzwahrscheinlichkeit übersteigt, und die Blitzwarnung in Form von einer Warnmitteilung ausgegeben wird.

2. Verfahren nach Anspruch 1, **dadurch gekennzeichnet, dass** die Windenergieanlagen Teil eines Windparks (10) sind und der Server ein Server (91) des Windparks (10) ist.

3. Verfahren nach Anspruch 1 oder 2, **dadurch gekennzeichnet, dass** der mindestens eine Wert für den Umweltparameter (25) mit einem Referenzwert verglichen wird.

4. Verfahren nach zumindest einem der Ansprüche 1 bis 3, **dadurch gekennzeichnet, dass** beim Auswerten der Karten (51) ein Minimalwert (64), ein Maximalwert (63) und/oder ein Gradient (64) ermittelt werden.

5. Verfahren nach zumindest einem der vorangehenden Ansprüche, **dadurch gekennzeichnet, dass** die Warnmitteilung als akustische Durchsage oder mit einer Warnleuchte ausgegeben wird.

6. System einer Mehrzahl von Windenergieanlagen (10) ausgebildet zur Blitzwarnung, wobei jede Windenergieanlage (1) der Mehrzahl der Windenergieanlagen (1) jeweils an einem Standort (1.1, 1.2, ... , m.n) steht und jede der Windenergieanlagen (1) eine Sensoranordnung (5) zur Erfassung eines Umweltparameters aufweist, umfassend wenigstens einen Windmesser (21), einen Temperatursensor (22) und/oder einen Feuchtigkeitssensor (23), wobei die Sensoranordnung (5) mit einem weiteren Sensor (24), nämlich ein Elektrofeldmeter, zum Erfassen eines elektrischen Feldes gebildet ist; und eine Blitzwarneinrichtung mit einer Auswerteeinheit zum Auswerten (44) des mindestens einen Wertes für den Umweltparameter, wenigstens umfassend ein elektrisches Feld, und zum Vorhersagen (45) der Blitzwarnung für die Standorte (1.1, 1.2, ... , m.n) der Windenergieanlagen (1) gebildet ist **dadurch gekennzeichnet, dass** in dem System die Mehrzahl von Windenergieanlagen (10) mit einem Server (91) in Verbindung stehen und dieser und die Blitzwarneinrichtung konfiguriert sind, ein Verfahren nach einem der Ansprüchen 1 bis 5 auszuführen.

## Claims

1. Method for warning of lightning having a system of a plurality of wind turbines (1), wherein the wind turbines (1) each stand at a location (1.1, 1.2, ... m.n) and each of the plurality of wind turbines (1) has a sensor arrangement (5) for detecting an environmental parameter, comprising at least a wind gauge (21), a temperature sensor (22) and/or a moisture sensor (23), wherein the sensor arrangement (5) has an additional sensor (24), that is to say, a field mill, for detecting electrical fields, and the method comprises the following steps:
- detecting (41) at least one value for the environmental parameter (25), at least comprising an electrical field, using the sensors (21, 22, 23, 24) of the sensor arrangement (5) having the plurality of wind turbines (1); and
- evaluating (44) the at least one value for the environmental parameter for predicting (45) the lightning warning (1) for the locations (1.1, 1.2, ... m.n) of the plurality of wind turbines (1), **characterised in that**
- in the system the plurality of wind turbines (1) are connected to a common central server (91),
wherein the method further comprises the following steps:
- transmitting (42) the at least one value for the environmental parameters (25) from the plurality of wind turbines (1) to the server (31);
- producing (43) a chart (51) with the at least one value for the environmental parameter (25) and the location (1.1, 1.2, ... m.n) of the plurality of wind turbines (1); and
- evaluating (44) the chart (51) for predicting (45) the lightning warning (1) for the locations (1.1, 1.2, ... m.n) of the plurality of wind turbines (1), wherein
- with each sensor arrangement (5) of the plurality of wind turbines (1) a plurality of values for the environmental parameter (25) are detected, and with the plurality of values for the environmental parameter (51) a plurality of charts (51) are produced and evaluated, and the plurality of charts (25) are combined with each other, wherein,
- based on the evaluation of the plurality of charts (51), probabilities for a lightning strike are associated with the locations (1.1, 1.2, ... m.n) of the plurality of wind turbines (1), wherein for the establishment of the probabilities standard models and/or experience values from the weather forecast are used, wherein
- the plurality of values for the environmental parameter (25) are selected from the following group of values: wind strength (21.1a), wind direction (21.1b), temperature (22.1), air humidity (23.1), air pressure, electric field strength (24.1), magnetic field strength and electromagnetic field strength, and
- the probabilities of a lightning strike are compared with limit probabilities and a lightning warning is output for the locations (1.1, 1.2, ... m.n) of the plurality of wind turbines (1) at which the probability of the lightning strike exceeds the limit probability, and the lightning warning is output in the form of a warning message.

2. Method according to claim 1, **characterised in that** the wind turbines are part of a wind park (10) and the server is a server (91) of the wind park (10).

3. Method according to claim 1 or 2, **characterised in that** the at least one value for the environmental parameter (25) is compared with a reference value.

4. Method according to at least one of claims 1 to 3, **characterised in that**, when the charts (51) are evaluated, a minimum value (64), a maximum value (63) and/or a gradient (64) are established.

5. Method according to at least one of the preceding claims, **characterised in that** the warning message is output as an acoustic announcement or with a warning light.

6. System of a plurality of wind turbines (1) constructed for lightning warning, wherein each wind turbine (1) of the plurality of wind turbines (1) stands at a location (1.1, 1.2, ... m.n) and each of the wind turbines (1) has a sensor arrangement (5) for detecting an environmental parameter, comprising at least a wind gauge (21), a temperature sensor (22) and/or a moisture sensor (23), wherein the sensor arrangement (5) is formed with an additional sensor (24), that is to say, a field mill, for detecting an electric field; and a lightning warning device is formed with an evaluation unit for evaluating (44) the at least one value for the environmental parameter, at least comprising an electric field and for predicting (45) the lightning warning for the locations (1.1, 1.2, ... m.n) of the wind turbines (1), **characterised in that** in the system the plurality of wind turbines (1) are connected to a server (91) and this server and the lightning warning device are configured to carry out a method according to any one of claims 1 to 5.

## Revendications

1. Procédé pour l'alerte de foudre avec un système d'une pluralité d'éoliennes (1) dans lequel les éoliennes (1) se trouvent respectivement sur un site (1.1, 1.2, ..., m.n) et chacune de la pluralité d'éoliennes (1) présente un ensemble de capteurs (5) pour la détection d'un paramètre environnemental, comprenant au moins un anémomètre (21), un capteur de température (22) et/ou un capteur d'humidité (23), dans lequel l'ensemble de capteurs (5) présente un autre capteur (24), à savoir un appareil de mesure de champ électrique, pour la détection de champs électriques, et le procédé comprend les étapes suivantes :
- détection (41) d'au moins une valeur pour le paramètre environnemental (25), comprenant au moins un champ électrique, à l'aide des capteurs (21, 22, 23, 24) de l'ensemble de capteurs (5) avec la pluralité d'éoliennes (1) ; et
- évaluation (44) de l'au moins une valeur pour le paramètre environnemental pour la prédiction (45) de l'alerte de foudre (1) pour les sites (1.1, 1.2, ..., m.n) de la pluralité d'éoliennes (1), **caractérisé en ce que**
- dans le système, la pluralité d'éoliennes (1) communique avec un serveur central commun (91),
dans lequel le procédé comprend en outre les étapes suivantes :
- envoi (42) de l'au moins une valeur pour le paramètre environnemental (25) de la pluralité d'éoliennes (1) au serveur (31) ;
- création (43) d'une carte (51) avec l'au moins une valeur pour le paramètre environnemental (25) et le site (1.1, 1.2, ..., m.n) de la pluralité d'éoliennes (1) ; et
- évaluation (44) de la carte (51) pour la prédiction (45) de l'alerte de foudre (1) pour les sites (1.1, 1.2, ..., m.n) de la pluralité d'éoliennes (1), dans lequel
- avec chaque ensemble de capteurs (5) de la pluralité d'éoliennes (1), plusieurs valeurs pour le paramètre environnemental (25) sont détectées, et avec les plusieurs valeurs pour le paramètre environnemental, plusieurs cartes (51) sont créées et évaluées, et les plusieurs cartes (25) sont combinées les unes avec les autres, dans lequel
- des probabilités d'un impact de foudre sont affectées aux sites (1.1, 1.2, ..., m.n) de la pluralité d'éoliennes (1) sur la base de l'évaluation des plusieurs cartes (51), dans lequel la détermination des probabilités a recours à des modèles standards et/ou à des valeurs empiriques de la prévision météorologique, dans lequel
- les plusieurs valeurs pour le paramètre environnemental (25) sont sélectionnées parmi le groupe suivant de valeurs : force du vent (21.1a), direction du vent (21.1b), température (22.1), humidité de l'air (23.1), pression atmosphérique, intensité du champ électrique (24.1), intensité du champ magnétique et intensité du champ électromagnétique, et
- les probabilités d'un impact de foudre sont comparées avec des probabilités limites et une alerte de foudre est émise pour les sites (1.1, 1.2, ..., m.n) de la pluralité d'éoliennes (1), pour lesquels la probabilité de l'impact de foudre dépasse la probabilité limite, et l'alerte de foudre est émise sous la forme d'un message d'alerte.

2. Procédé selon la revendication 1, **caractérisé en ce que** les éoliennes font partie d'un parc éolien (10) et le serveur est un serveur (91) du parc éolien (10).

3. Procédé selon la revendication 1 ou 2, **caractérisé en ce que** l'au moins une valeur pour le paramètre environnemental (25) est comparée avec une valeur de référence.

4. Procédé selon au moins l'une quelconque des revendications 1 à 3, **caractérisé en ce que**, lors de l'évaluation des cartes (51), une valeur minimale (64), une valeur maximale (63) et/ou un gradient (64) sont déterminés.

5. Procédé selon au moins l'une quelconque des revendications précédentes, **caractérisé en ce que** le message d'alerte est émis en tant que notification acoustique ou avec un avertisseur lumineux.

6. Système d'une pluralité d'éoliennes (10) réalisées pour l'alerte de foudre, dans lequel chaque éolienne (1) de la pluralité d'éoliennes (1) se trouve respectivement sur un site (1.1, 1.2, ..., m.n) et chacune des éoliennes (1) présente un ensemble de capteurs (5) pour la détection d'un paramètre environnemental, comprenant au moins un anémomètre (21), un capteur de température (22) et/ou un capteur d'humidité (23), dans lequel l'ensemble de capteurs (5) est formé avec un autre capteur (24), à savoir un appareil de mesure de champ électrique, pour la détection d'un champ électrique ; et un dispositif d'alerte de foudre est formé avec une unité d'évaluation pour l'évaluation (44) de l'au moins une valeur pour le paramètre environnemental, comprenant au moins un champ électrique, et pour la prédiction (45) de l'alerte de foudre pour les sites (1.1, 1.2, ..., m.n) des éoliennes (1) **caractérisé en ce que**, dans le système, la pluralité d'éoliennes (10) communique avec un serveur (91) et celui-ci et le dispositif d'alerte de foudre sont configurés pour exécuter un procédé selon l'une quelconque des revendications 1 à 5.
